(19) Europäisches Patentamt European Patent Office Office européen des brevets

(11) **EP 2 302 107 A1**

(12) **EUROPEAN PATENT APPLICATION**

(43) Date of publication:
**30.03.2011 Bulletin 2011/13**

(21) Application number: **09171219.0**

(22) Date of filing: **24.09.2009**

(51) Int Cl.:
*C30B 1/04* *(2006.01)*      *C30B 29/22* *(2006.01)*
*C30B 29/28* *(2006.01)*      *C30B 33/02* *(2006.01)*
*B01J 3/06* *(2006.01)*      *C30B 29/34* *(2006.01)*

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(71) Applicant: **Schott AG**
**55122 Mainz (DE)**

(72) Inventors:
• **Okano, Yoshio**
**Ibaraki Tsukuba 300-264 (JP)**
• **Peuchert, Ulrich**
**55294 Bodenheim (DE)**

• **Menke, Yvonne**
**55130 Mainz (DE)**
• **Gross, Christoph**
**60316 Frankfurt (DE)**

(74) Representative: **Fuchs**
**Patentanwälte**
**Westhafenplatz 1**
**60327 Frankfurt am Main (DE)**

Remarks:
Amended claims in accordance with Rule 137(2) EPC.

(54) **Scintillator single crystals produced by solid state crystal growth from ceramic powder**

(57) The invention relates to single crystal scintillator material comprising an active ion and a process for its production. The scintillator is produced by solid state crystal growth from ceramic precursors, wherein specific atmospheres and pressures are applied to the material.

The resulting scintillator is perfectly suited to be used, for example, in PET applications. Among the superior properties of the scintillator is a very good light yield.

**EP 2 302 107 A1**

**Description**

The present invention refers to a single crystal scintillator material comprising at least one active ion and a process for its production. The scintillator according to the present invention is produced by solid state crystal growth from ceramic precursors.

There are two major groups of scintillator materials, polycrystalline ceramics and single crystals.

Polycrystalline ceramics have the advantage of being easily obtainable by sintering appropriate starting materials. However, polycrystalline ceramics suffer the disadvantage of comprising grain boundaries which scatter incoming light, thus reducing transmission.

Single crystals are composed of a single unitary crystallite not comprising any grain boundaries. Therefore, no scattering takes place in single crystals and transmission properties are usually improved when compared to respective polycrystalline ceramics. However, production of single crystals is very expensive as the starting materials have to be treated at very high temperatures for long periods.

Consequently, polycrystalline ceramics are superior when it comes to cost effectiveness of a scintillator and single crystals are superior when it comes to optimized optical properties.

Many efforts have been made in order to render production of single crystals more cost effective. One of these methods is solid state crystal growth from ceramic precursors. In this process a ceramic polycrystalline body is manufactured from appropriate starting material. In a subsequent step a so called seed crystal, which is a single crystal, is attached to the ceramic body thereby defining a crystallographic direction of crystal growth to the polycrystalline ceramic body. Afterwards, this combined body of polycrystalline ceramic and seed crystal is heated to a certain elevated temperature so that a single crystal is formed. This technique leads to single crystals obtainable in a comparatively cost effective way. This technique is described in US 2008/0047482 A1.

Nevertheless, the solid state crystal growth from ceramic precursors still suffers significant disadvantages. While single crystals do not comprise any grain boundaries, they normally have crystal defects that decrease light yield in case the single crystal is used as a scintillator.

In the past it was thought that single crystals show transmission and light yields that are close to the theoretical limit for the respective material. However, a single crystal of lutetium silicate, which has been grown from the melt, only shows half the light yield of the theoretical limit. This is due to defects in the crystal structure acting as trapping sites for excited electrons.

Consequently, there is a need to produce single crystal material in a cost effective way exhibiting properties superior to conventional single crystals. Such superior single crystals would provide higher energy resolution, thus reducing the signal to noise ratio and providing for better image quality in, for example, PET (positron emission tomography).

The present invention provides for such an improved single crystal scintillator material.

The single crystal scintillator material of the present invention has a light yield of > $3.5*10^4$ photons/MeV, comprises at least one active ion and is obtainable by carrying out a method comprising the following steps:

> a. providing a polycrystalline ceramic body from a starting material,
> b. attaching a seed crystal to the ceramic body thereby obtaining a combined body,
> c. heating the combined body to a conversion temperature thereby initiating the ceramic body to convert into a single crystal,

wherein the process further comprises the steps of

> d. annealing the single crystal in a first atmosphere and
> e. post-annealing the single crystal in a second atmosphere.

The single crystal scintillator obtained by carrying out the above-mentioned steps has a superior light yield when compared to single crystals in the art. Light yield of the single crystal is derived from pulse height spectrum (PHS) of a photomultiplier (PMT) signal of scintillation light by using the single photoelectron method. In the single photoelectron method, the measured photo peak position from scintillating light on the PHS is compared to the position of single photoelectron on the PHS, which is generated by a single electron released from a photocathode of PMT.

The photo peak position generated by scintillation light from the single crystal is measured as follows: a disk-like sample of 10mm$\phi$ x 2mm$^t$ of the single crystal is used for the measurement of light yield. Two flat surfaces of the sample are polished with the quality of "optical polish" and the round surface is as ground. The sample is optically coupled with an optical window of the PMT (XP2020, PHOTONIS, France) by using silicone grease (Oken 6262A, Ohyo Koken Kogyo Co., Ltd, JPN). The surfaces of the sample which do not face to the optical window are covered by 5 layers or more of Teflon tape (Tape Seal #20, Nippon Valqua Industries, Ltd) in order to confine scintillating light and to introduce all the scintillating light into the PMT.

The sample is activated by gamma ray from $^{137}$Cs source with radioactivity of 10kBq and the source is placed just above the sample. The setup consisting of gamma ray source, the sample and the PMT is placed in a dark box in order to eliminate the irradiation of non-scintillating light into the PMT. Photons of the scintillation light from the sample are converted to photoelectrons at the photocathode of the PMT with the certain quantum efficiency (QE) and the photoelectrons are multiplied by the PMT. The driving voltage of the PMT, i.e. voltage between photocathode and anode of the PMT, is fixed at 3000V.

The signals from PMT, i.e. current pulses, are amplified by a preamplifier (113 Scintillation Preamplifier, ORTEC, U.S.). Then the amplified pulses are shaped by shaping amplifier (570 Amplifier, ORTEC, U.S.) at the shaping time of 1 $\mu$s. Gain of the amplifier is adjusted as mentioned below. The shaped pulses are converted into digital signals and then the PHS of the pulses is recorded by a multichannel analyzer (EASY-MCA-8k, ORTEC, U.S.). The number of channels of PHS is fixed at 4k and the gain of the shaping amplifier (Gp) is adjusted so that the photo peak corresponding to 662 keV from $^{137}$Cs is fully covered within the range of 4k channels and that the peak top of the photo peak positions at around 80 % of full channels of PHS. The channel number ($CN_p$) of the peak top of the photo peak corresponding to 662 keV is identified as the position of the photo peak.

Prior to the PHS analysis of the single crystal, the single crystal is kept in the dark box for 12 hours to eliminate the interference from afterglow.

The position of single photoelectron on the PHD is measured by using same setup for the photo peak position mentioned above without using $^{137}$Cs gamma-ray source. Even if gamma-ray source is missing, photoelectron is thermally activated at the photocathode of the PMT. As this event is not so frequent, multiplied pulse from thermally activated single electron (single photoelectron) can be observed by using the setup mentioned above if the gain of sampling amplifier is big enough ($G_s$). The position of the single photoelectron is given by the channel number of the peak top of the single electron photo peak on the PHD ($CN_s$).

In the single photoelectron method, the measured photo peak position from scintillation light is compared to the position of thermally induced single photoelectron, and the light yield (LY) of the single crystal is calculated according to the equation 1.

$$LY = (CN_p \times G_s)/(0.662 \times QE \times CN_s \times G_p) \quad [\text{photons/ MeV}] \quad (1)$$

Experiments have shown that the annealing step is needed to obtain superior single crystal scintillator material because mesoscopic defects that are generated during the conversion process from polycrystalline ceramics to single crystals are removed by this annealing step. The aim of the present invention is best achieved in case the first atmosphere comprises the preferred components hydrogen, helium or vacuum.

The post-annealing step is needed to remove microscopic defects like point defects and dislocations that are generated during the conversion process and the annealing process. The combination of annealing step and post-annealing step provides for the superior scintillator material of the present invention. This aim is best achieved in case the second atmosphere is an oxidizing atmosphere. Preferably, the second atmosphere comprises oxygen. In preferred embodiments, the second atmosphere additionally comprises an inert gas, especially nitrogen or argon. In alternative embodiments, the second atmosphere is air. In embodiments, where the second atmosphere comprises oxygen, its partial pressure exceeds 0.01 atm.

The post-annealing step takes place at temperatures of from 1000 to 1800 °C. It has surprisingly been found that conducting a post-annealing step at these temperatures, which are below the temperatures of the annealing step, microscopic defects can be removed from the single crystal so that light yield is improved. The result of post-annealing can be further improved in case it is conducted in a preferable pressure range of from 10 to 1013 hPa.

If the active ion is oxidized during the post-annealing, an additional annealing step in hydrogen atmosphere, i.e. an atmosphere comprising hydrogen and preferably consisting of hydrogen to an extent of at least 95% VN, is effective to reduce the oxidized active ion. Therefore, preferred embodiments comprise the step of such an additional annealing step. The preferable temperature of the additional annealing step is 1000 to 1600°C.

The conversion temperature in which the combined body is converted from a polycrystalline material into a single crystal is preferably in the range of from 100 K to 300 K below the melting point of the ceramic body.

It is preferred that the polycrystalline ceramic body is obtained from the starting material by a sintering step. Prior to the sintering step, the starting material is preferably provided as a powder having a primary particle grain size of 20 to 500 nm as determined with an electron microscope such as SEM or TEM. This powder is then preferably mixed with binders, dispersing agents and sinter additives. Preferably, this mixture is molded to obtain a molded body. Before sintering the molded body is preferably pre-sintered at temperatures of from 500°C to 900°C, preferably during a period of from 0.5 to 15 hours. This is preferably done in oxidative atmosphere to eliminate organic residue from binder and/ or dispersant.

Afterwards, the sintering step preferably takes place at pressures of from $10^{-7}$ bar to 1 bar, preferably $10^{-7}$ bar to $10^{-3}$ bar. It is preferred that the sintering step takes place at these low pressures because lowering the pressure decreases the amount of gaseous artifacts in the ceramic body. The temperature range in which the sintering step preferably takes place is from 1,400°C to 2,000°C, preferably from 1,500°C to 1,900°C and most preferably from 1,600°C to 1,850°C. Sintering preferably takes 0.5 to 15 hours.

After the sintering step the sintered body is preferably pressurized (HIP) at pressures between 10 MPa and 300 MPa, preferably between 50 MPa and 250 MPa and most preferably between 100 MPa and 200 MPa. This is preferably done at a temperature ranging from 1500 to 2000 °C. More preferably the temperature range is 1600 to 1900 °C. The sintered body is preferably pressurized for 0.5 to 15 hours.

The seed crystal which is attached to the ceramic body is preferably of the same material as the starting material. The starting material preferably comprises lutetium and the starting material preferably comprises an oxide.

Experiments have shown that combination of the annealing step and the post-annealing step has great influence on the quality of single crystals that comprise lutetium-containing oxides. Most preferred starting materials comprise lutetium silicate, lutetium yttrium silicate, lutetium aluminate, LPS, LYPS, LuAP, LuYAP, lutetium aluminum granate, lutetium hafnate.

In a preferred embodiment the single crystal scintillator material according to the present invention, the starting material comprises lutetium silicate (LSO).

In an alternative embodiment the starting material comprises lutetium yttrium silicate (LYSO).

In an alternative embodiment the starting material comprises lutetium aluminate.

In an alternative embodiment the starting material comprises lutetium pyrosilicate (LPS).

In an alternative embodiment the starting material comprises lutetium yttrium pyrosilicate (LYPS).

In an alternative embodiment the starting material comprises lutetium aluminum perovskite (LuAP).

In an alternative embodiment the starting material comprises lutetium yttrium aluminum perovskite (LuYAP).

In an alternative embodiment the starting material comprises lutetium aluminum granate.

In an alternative embodiment the starting material comprises lutetium hafnate.

In an alternative embodiment the starting material comprises gadolinium hafnate.

In an alternative embodiment the starting material comprises lutetium aluminate

Crystallization is done by heating the seed crystal attached to the ceramic body to a temperature in the range from 1400°C to 2000°C. Duration of the crystallization process depends on the length measured between the interface of the seed crystal and the ceramic body to the opposite end of the ceramic body. The atmosphere in which this step takes place is preferably an inert gas, especially $N_2$ or Ar, or vacuum, especially in case the heating element of the heating furnace is metal or carbon.

Irrespective of the composition of the starting material, the material used shall preferably have cubic crystal structure. Most preferred the cubic crystal structure is of the pyrochlore type. Experiments have shown that the effect of the post-annealing step on microscopic defects is very beneficial on crystallites with cubic crystal structure.

The active ion present in the scintillator material of the present invention is preferably selected from $Ce^{3+}$ and $Pr^{3+}$. Preferably the content of these active ions is from 0.01 to 10 at%.

In preferred embodiments, the scintillator of the present invention is a y-ray scintillator.

**Examples**

|  | Example 1 | Example 2 | Example 3 |
|---|---|---|---|
| Host crystal | LSO | LSO | LSO |
| Active ion/content | $Ce^{3+}$/0.1% | $Ce^{3+}$/0.1% | $Ce^{3+}$/0.1% |
| Sintering | 1800°C/5h | 1800°C/5h | 1800°C/5h |
| HIP | 1700°C/200MPa/2h | 1700°C/200MPa/2h | 1700°C/200MPa/2h |
| Crystallization | 1700°C | 1700°C | 1700°C |
| Seed crystal | LSO | LSO | LSO |
| Post annealing | 1400°C/1h | 1600°C/1h | 1800°C/1h |
| $H_2$-annealing | none | none | none |
| Light yield (photons/MeV) | 3.6x10^4 | 4.1x10^4 | 4.5x10^4 |

|  | Example 4 | Example 5 |
|---|---|---|
| Host crystal | LSO | LSO |
| Active ion/content | $Ce^{3+}$/0.1% | $Ce^{3+}$/0.1% |
| Sintering | 1800°C/5h | 1800°C/5h |

| HIP | 1700°C/200MPa/2h | none |
|---|---|---|
| Crystallization | 1700°C | 1700°C |
| Seed crystal | LSO | LSO |
| Post annealing | 1600°C/1h | 1600°C/1h |
| $H_2$-annealing | 1400°C/1h | none |
| Light yield (photons/MeV) | 4.2x10^4 | 4.0x10^4 |

|  | Comparative 1 | Comparative 2 | Comparative 3 |
|---|---|---|---|
| Host crystal | LSO | LSO | LSO (conventional single crystal) |
| Active ion/content | $Ce^{3+}$/0.1% | $Ce^{3+}$/0.1% | $Ce^{3+}$/0.05% |
| Sintering | 1800 °C/ 5 h | 1800 °C/ 5 h | none |
| HIP | 1700°C/200MPa/2h | 1700°C/200MPa/2h | none |
| Crystallization | none | 1700°C | none |
| Seed crystal | none | LSO | none |
| Post annealing | none | none | none |
| $H_2$-annealing | none | none | none |
| Light yield (photons/MeV) | 2.3x10^4 | 2.6x10^4 | 3.1x10^4 |

**Claims**

1. Single crystal scintillator material comprising at least one active ion, the scintillator material having a light yield of >3.5*10^4 photons/MeV obtainable by carrying out a method comprising the following steps:

a. providing a polycrystalline ceramic body from a starting material,
b. attaching a seed crystal to the ceramic body thereby obtaining a combined body,
c. heating the combined body to a conversion temperature thereby initiating the ceramic body to convert into a single crystal,

**wherein** the process further comprises the step of

d. annealing the single crystal in a first atmosphere and
e. post-annealing the single crystal in a second atmosphere.

2. The single crystal scintillator material according to claim 1, wherein the conversion temperature is in the range of from 100 K to 300 K below the melting point of the ceramic body.

3. The single crystal scintillator material according to claim 1 or 2, wherein the post-annealing takes place at temperatures of 1000 to 1800 °C.

4. The single crystal scintillator material according to one or more of the preceding claims, wherein the ceramic body is obtained by sintering the starting material.

5. The single crystal scintillator material according to one or more of the preceding claims, wherein the ceramic body is made from a powder of the starting material having a primary particle grain size of 20 to 500 nm.

6. The single crystal scintillator material according to one or more of the preceding claims, wherein the ceramic body is made by mixing a powder of the starting material with binders, dispersing agents and sinter additives and molding this mixture to obtain a molded body.

7. The single crystal scintillator material according to one or more of the preceding claims, wherein the step of providing the ceramic body includes preparing a molded body from the starting material and pre-sintering the molded body at temperatures of from 500°C to 900°C.

8. The single crystal scintillator material according to one or more of the preceding claims, wherein the step of providing the ceramic body includes sintering in a pressure range of from $10^{-7}$ bar to 1 bar, preferably $10^{-7}$ bar to $10^{-3}$ bar.

9. The single crystal scintillator material according to one or more of the preceding claims, wherein the step of providing the ceramic body includes sintering at a temperature of from 1400°C to 2000°C, preferably from 1500°C to 1900°C and most preferably from 1600°C to 1850°C.

10. The single crystal scintillator material according to one or more of the preceding claims, wherein the step of providing the ceramic body includes the step of pressurizing the molded body at pressures between 10 MPa and 300 MPa, preferably between 50 MPa and 250 MPa and most preferably between 100 MPa and 200 MPa.

11. The single crystal scintillator material according one or more of the preceding claims, wherein the ceramic body is obtained by sintering the starting material during a period of 0.5 to 15 hours.

12. The single crystal scintillator material according one or more of the preceding claims, wherein the first atmosphere comprises hydrogen, helium or vacuum.

13. The single crystal scintillator material according one or more of the preceding claims, wherein the second atmosphere comprises oxygen.

**Amended claims in accordance with Rule 137(2) EPC.**

1. Single crystal scintillator material comprising lutetium silicate (LSO), lutetium yttrium silicate (LYSO), lutetium aluminate, lutetium pyrosilicate (LPS), lutetium yttrium pyrosilicate (LYPS), lutetium aluminium perovskite (LuAP), lutetium yttrium aluminium perovskite (LuYAP), lutetium aluminium granate and lutetium hafnate, and at least one active ion, the scintillator material having a light yield of $>3.5*10^4$ photons/MeV obtainable by carrying out a method comprising the following steps:

a. providing a polycrystalline ceramic body from a starting material,

b. attaching a seed crystal to the ceramic body thereby obtaining a combined body,

c. heating the combined body to a conversion temperature thereby initiating the ceramic body to convert into a single crystal,

wherein the process further comprises the step of

d. annealing the single crystal in a first atmosphere and

e. post-annealing the single crystal in a second atmosphere.

**2.** The single crystal scintillator material according to claim 1, wherein the conversion temperature is in the range of from 100 K to 300 K below the melting point of the ceramic body.

**3.** The single crystal scintillator material according to claim 1 or 2, wherein the post-annealing takes place at temperatures of 1000 to 1800 °C.

**4.** The single crystal scintillator material according to one or more of the preceding claims, wherein the ceramic body is obtained by sintering the starting material.

**5.** The single crystal scintillator material according to one or more of the preceding claims, wherein the ceramic body is made from a powder of the starting material having a primary particle grain size of 20 to 500 nm.

**6.** The single crystal scintillator material according to one or more of the preceding claims, wherein the ceramic body is made by mixing a powder of the starting material with binders, dispersing agents and sinter additives and molding this mixture to obtain a molded body.

**7.** The single crystal scintillator material according to one or more of the preceding claims, wherein the step of providing the ceramic body includes preparing a molded body from the starting material and pre-sintering the molded body at temperatures of from 500°C to 900°C.

**8.** The single crystal scintillator material according to one or more of the preceding claims, wherein the step of providing the ceramic body includes sintering in a pressure range of from $10^{-7}$ bar to 1 bar, preferably $10^{-7}$ bar to $10^{-3}$ bar.

**9.** The single crystal scintillator material according to one or more of the preceding claims, wherein the step of providing the ceramic body includes sintering at a temperature of from 1400°C to 2000°C, preferably from 1500°C to 1900°C and most preferably from 1600°C to 1850°C.

**10.** The single crystal scintillator material according to one or more of the preceding claims, wherein the step of providing the ceramic body includes the step of pressurizing the molded body at pressures between 10 MPa and 300 MPa, preferably between 50 MPa and 250 MPa and most preferably between 100 MPa and 200 MPa.

**11.** The single crystal scintillator material according one or more of the preceding claims, wherein the ceramic body is obtained by sintering the starting material during a period of 0.5 to 15 hours.

**12.** The single crystal scintillator material according one or more of the preceding claims, wherein the first atmosphere comprises hydrogen, helium or vacuum.

**13.** The single crystal scintillator material according one or more of the preceding claims, wherein the second atmosphere comprises oxygen.

**14.** Method for the production of a single crystal scintillator material comprising lutetium silicate (LSO), lutetium yttrium silicate (LYSO), lutetium aluminate, lutetium pyrosilicate (LPS), lutetium yttrium pyrosilicate (LYPS), lutetium aluminium perovskite (LuAP), lutetium yttrium aluminium perovskite (LuYAP), lutetium aluminium granate and lutetium hafnate, according to one or more of the preceding claims with the following steps:

a. providing a polycrystalline ceramic body from a starting material,

b. attaching a seed crystal to the ceramic body thereby obtaining a combined body,

c. heating the combined body to a conversion temperature thereby initiating the ceramic body to convert into a single crystal,

d. annealing the single crystal in a first atmosphere and
e. post-annealing the single crystal in a second atmosphere.

Europäisches
Patentamt

European
Patent Office

Office européen
des brevets

## EUROPEAN SEARCH REPORT

Application Number

EP 09 17 1219

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KRAMER K W ET AL: "Development and characterization of highly efficient new cerium doped rare earth halide scintillator materials" JOURNAL OF MATERIALS CHEMISTRY R. SOC. CHEM UK, vol. 16, no. 27, 21 June 2006 (2006-06-21), pages 2773-2780, XP002575184 ISSN: 0959-9428 * page 2775, column 2, line 29 - page 2779, column 1, line 7; figures 6-8; table 1 * | 1-13 | INV. C30B1/04 C30B29/22 C30B29/28 C30B33/02 B01J3/06 C30B29/34 |
| A,D | US 2008/047482 A1 (VENKATARAMANI VENKAT SUBRAMANI [US] VENKATARAMANI VENKAT SUBRAMANIAM []) 28 February 2008 (2008-02-28) * paragraph [0021] - paragraph [0041]; claims 1-31; figures 1-3; examples 1-2 * | 1-13 | |
| A | DARIUSZ J WISNIEWSKI ET AL: "Development of Novel Polycrystalline Ceramic Scintillators" IEEE TRANSACTIONS ON NUCLEAR SCIENCE, IEEE SERVICE CENTER, NEW YORK, NY, US, vol. 55, no. 3, 1 June 2008 (2008-06-01), pages 1501-1508, XP011216755 ISSN: 0018-9499 * page 1502, column 1, line 2 - page 1505, column 1, line 2; figures 2-8 * | 1-13 | TECHNICAL FIELDS SEARCHED (IPC) C30B B01J |

The present search report has been drawn up for all claims

| Place of search | Date of completion of the search | Examiner |
|---|---|---|
| The Hague | 25 March 2010 | Lavéant, Pierre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 09 17 1219

This annex lists the patent family members relating to the patent documents cited in the above-mentioned European search report.
The members are as contained in the European Patent Office EDP file on
The European Patent Office is in no way liable for these particulars which are merely given for the purpose of information.

25-03-2010

| Patent document cited in search report | Publication date | Patent family member(s) | Publication date |
|---|---|---|---|
| US 2008047482 A1 | 28-02-2008 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20080047482 A1